Europäisches Patentamt

European Patent Office

Office européen des brevets

(19)

(11) **EP 0 932 183 B1**

(12) **FASCICULE DE BREVET EUROPEEN**

(45) Date de publication et mention
de la délivrance du brevet:
**01.10.2003 Bulletin 2003/40**

(51) Int Cl.⁷: **H01J 37/32**

(21) Numéro de dépôt: **99400164.2**

(22) Date de dépôt: **25.01.1999**

(54) **Source à plasma micro-onde linéaire en aimants permanents**

Lineare Mikrowellenplasmaquelle mit Permanentmagneten

Linear microwave plasma source with permanent magnets

(84) Etats contractants désignés:
**CH DE FR GB IT LI NL**

(30) Priorité: **26.01.1998 FR 9800777**

(43) Date de publication de la demande:
**28.07.1999 Bulletin 1999/30**

(73) Titulaire: **COMMISSARIAT A L'ENERGIE ATOMIQUE**
**75015 Paris Cédex 15 (FR)**

(72) Inventeur: **Delaunay, Marc**
**38240 Meylan (FR)**

(74) Mandataire: **Audier, Philippe André et al**
**Brevalex,**
**3, rue du Docteur Lancereaux**
**75008 Paris (FR)**

(56) Documents cités:
**DE-A- 4 230 291          US-A- 5 302 266**

- **PATENT ABSTRACTS OF JAPAN vol. 018, no. 033 (E-1493), 18 janvier 1994 & JP 05 266993 A (HITACHI LTD), 15 octobre 1993**
- **MARITO MATSUOKA ET AL: "A FEW TECHNIWUES FOR PREPARING CONDUCTIVE MATERIAL FILMS FOR SPUTTERING-TYPE ELECTRON CYCLOTRON RESONANCE MICROWAVE PLASMA" JAPANESE JOURNAL OF APPLIED PHYSICS, vol. 28, no. 3, 1 mars 1989, pages L503-506, XP000118423**
- **BERRY L A ET AL: "PERMANENT MAGNET ELECTRON CYCLOTRON RESONANCE PLASMA SOURCE WITH REMOTE WINDOW" JOURNAL OF VACUUM SCIENCE AND TECHNOLOGY: PART A, vol. 13, no. 2, 1 mars 1995, pages 343-348, XP000498541**
- **PATENT ABSTRACTS OF JAPAN vol. 012, no. 438 (C-544), 17 novembre 1988 & JP 63 162865 A (MATSUSHITA ELECTRIC IND CO LTD), 6 juillet 1988**

## Description

### Domaine technique

La présente invention concerne une source à plasma micro-onde linéaire en aimants permanents, pour le traitement ou le revêtement de surfaces par pulvérisation.

### Etat de la technique antérieure

Dans une source à résonance cyclotronique électronique, les ions sont obtenus en ionisant dans une enceinte fermée, du genre cavité hyperfréquence, un milieu gazeux, constitué d'un ou plusieurs gaz ou de vapeurs métalliques. Cette ionisation résulte d'une interaction entre le milieu gazeux et un ensemble d'électrons fortement accélérés par résonance cyclotronique électronique. Cette résonance est obtenue grâce à l'action conjuguée d'un champ électromagnétique micro-onde, injecté dans l'enceinte, et d'un champ magnétique régnant dans cette même enceinte.

La résonance cyclotron électronique permet de créer des plasmas denses à faible pression, sans filament ni cathode. Dans une réalisation décrite dans le document référencé [1] en fin de description, une source de plasma à résonance cyclotron électronique, constituée de deux guides d'ondes rectangulaires, est utilisée pour produire de forts flux d'ions dans le cadre de la synthèse de matériaux par pulvérisation.

L'injection d'une puissance micro-onde à la fréquence de 2,45 Ghz, dans une chambre à plasma comprenant une zone de résonance cyclotron électronique à 0,0875 Tesla, produit l'ionisation d'un gaz sous une pression faible de $10^{-4}$ à $10^{-3}$ mbar. Les ions et les électrons ainsi créés diffusent le long des lignes de champ magnétique jusqu'à une cible polarisée négativement. La pulvérisation est effectuée à -500 Volts et les substrats sont constitués de silicium ou de quartz. La hauteur du plasma est de 20 cm pour une largeur de 5 cm. Les densités électroniques, mesurées par interférométrie à 27 Ghz, atteignent $4 \times 10^{11}$ e/cm$^3$ pour l'argon et le krypton. Pour un plasma d'oxygène, la densité de courant d'ions est de 40 mA/cm$^2$.

L'indépendance du canon à plasma et de la cible permet de réaliser une grande variété de dépôts en continu, contrairement aux magnétrons :

- des couches de matériau magnétique (Fer) sur du quartz ont été obtenues avec une vitesse de 200 nm/mn (nanomètre/minute) à faible pression ;
- par pulvérisation réactive (plasmas d'oxygène et d'azote), des couches d'oxydes ($Al_2O_3$ - transparent et stoechiométrique $Cr_2O_3$) et de nitrure (A1N) ont été réalisées avec des vitesses de 10 à 20 nm/mn (avec un mélange argon-oxygène adéquat, il est possible d'atteindre des vitesses de 100 nm/mn : c'est un problème d'oxydation de cible pour l'alumine). Le procédé ne nécessite pas d'alimentation de polarisation RF comme pour les magnétrons. Une simple alimentation continue permet d'effectuer tous les dépôts ;

- les dépôts à basse pression ($10^{-4}$ millibars) diminuent la proportion de gaz inclus dans les couches et induisent une augmentation de la densité du matériau (environ 7 g/cm$^3$ pour des revêtements de chrome sur du silicium) ;
- des couches de carbone de type diamant ont été réalisées par pulvérisation de cible de carbone (substrat polarisé) ou par la dissociation de méthane ;
- l'usure des cibles est homogène sur toute la surface pulvérisée contrairement aux magnétrons.

Les sources de plasma à résonance cyclotron électronique ont été largement utilisées pour la synthèse de matériaux depuis une dizaine d'années. Pour le dépôt par pulvérisation par des plasmas à résonance cyclotron électronique, un effort particulier est développé principalement au Japon et aux Etats-Unis avec plusieurs sortes de dispositifs en fonction du type de matériau et de la dimension du substrat. Une description et une bibliographie succincte ont été effectuées dans la publication référencée [1] en fin de description.

- Les sources de plasma micro-ondes à résonance cyclotron électronique les plus utilisées pour les dépôts par pulvérisation sont constituées d'une chambre à plasma cylindrique, de bobines de champs magnétiques qui créent une zone d'absorption à 0,0875 Tesla (875 Gauss) et permettent la diffusion du plasma jusqu'à une cible polarisée négativement. Les principaux inconvénients de ces sources sont l'utilisation de solénoïdes avec une forte consommation électrique, des cibles à pulvériser cylindriques en bordure du plasma (une faible partie du plasma interagit avec la cible) et le recouvrement des fenêtres d'étanchéité micro-onde par les atomes métalliques pulvérisés. De telles sources sont décrites dans les documents référencés [2], [3] et [4].

- Des dispositifs de plasma à résonance cyclotron électronique ont été réalisés avec des aimants permanents fixés sur un coude d'injection micro-onde à 90° et avec une zone d'absorption de l'onde située à l'intérieur d'une cible conique à pulvériser. L'inconvénient principal de ces dispositifs est le recouvrement très rapide d'une fenêtre micro-onde située à proximité de la zone de pulvérisation. De plus les vitesses de dépôt sont limitées. De tels dispositifs sont décrits dans le document référencé [5].

- Des sources de plasma à résonance cyclotron électronique en aimants permanents ont été développées au Japon avec des injections micro-ondes de type guides à fentes (« slot Antennas »). Les inconvénients principaux de ces sources sont la limitation de puissance micro-onde injectée (donc la limitation de la densité ionique à environ 10 mA/cm$^2$) et le recouvrement des fenêtres micro-ondes. De telles sources sont décrites dans le document référencé [6].

- Des plasmas à résonance cyclotron électronique ont été créés en utilisant les structures magnétiques des magnétrons (alternance de pôles des aimants permanents derrière la cible à pulvériser) et en injectant une puissance micro-onde. Les principaux inconvénients de ces structures sont la difficulté de pulvériser des matériaux magnétiques (la cible forme un écran), l'usure des cibles non uniforme (inutilisables après 30 % d'usure) et l'oxydation de la cible pour produire des oxydes (polarisation RF). De telles structures sont décrites dans les documents référencés [7] et [8].

- Des dispositifs de plasma à résonance cyclotron électronique ont été développés en utilisant une cible à pulvériser à l'intérieur du plasma de diffusion (inclinaison à 45°) avec deux ensembles de solénoïdes (fenêtre micro-onde à fort champ magnétique, création de la zone d'absorption à 0,0875 Tesla (875 Gauss) diffusion et compression du plasma sur la cible) pour obtenir de forts flux d'ions à faible pression (25 à 30 mA/cm$^2$ à $10^{-4}$ mbar) sur des surfaces extrapolables (les essais ont été effectués avec deux guides d'onde pour une hauteur de 20 cm). Une fenêtre micro-onde, située dans un coude à 90°, est protégée de tout recouvrement métallique. Les inconvénients présentés par ces dispositifs sont la consommation électrique des solénoïdes et l'inclinaison de la cible par rapport au substrat. De tels dispositifs sont décrits dans les documents référencés [1] et [9].

La présente invention a pour objet de pallier les inconvénients des dispositifs de l'art antérieur décrits ci-dessus.

Exposé de l'invention

La présente invention concerne une source à plasma micro-onde linéaire comprenant :

- une enceinte étanche ;
- des moyens pour créer un champ magnétique dans l'enceinte et générer une nappe de plasma ;
- des moyens de couplage entre des moyens d'émission micro-onde et la nappe de plasma dans l'enceinte ;
- une cible à pulvériser, isolée électriquement de l'enceinte et portée à une tension de polarisation négative, située dans la nappe de plasma ;

- des moyens de pompage pour faire le vide dans l'enceinte ;
- des moyens d'injection de gaz pour le contrôle des espèces ioniques de la nappe de plasma ; de manière à ce que les ions accélérés vers la cible permettent l'éjection d'atomes pulvérisés vers un substrat à traiter ;

caractérisé en ce que les moyens de couplage comprennent un guide d'injection micro-onde suivi d'un coude à 90° débouchant dans l'enceinte, perpendiculairement à celle-ci, une fenêtre micro-onde d'étanchéité étant située entre le guide d'injection micro-onde et le coude à 90°, de manière à produire l'ionisation du gaz en une zone de résonance cyclotron électronique située à quelques centimètres à l'intérieur du coude, qui est sous vide, et en ce que les moyens pour créer un champ magnétique comprennent un premier et un second aimants permanents disposés de part et d'autre de cette fenêtre, ces aimants étant installés avec une alternance de pôles.
Avantageusement la cible est refroidie grâce à un circuit de refroidissement comportant une canalisation d'amenée d'un liquide de refroidissement, et une canalisation de retour de ce liquide.
Dans un premier mode de réalisation un troisième aimant est disposé de l'autre côté de l'enceinte par rapport au premier aimant et au même niveau que celui-ci, le premier et le troisième aimant étant disposés en série de pôles.
Dans un second mode de réalisation le troisième aimant est disposé derrière la cible, le premier et le troisième aimant étant alors disposés en série de pôles.
Avantageusement la cible peut être disposée parallèlement au substrat. Le guide d'admission micro-onde peut avoir une hauteur qui augmente de son entrée vers sa sortie, connectée à la fenêtre micro-onde.
La source de dépôt par plasma micro-ondes de l'invention présente de nombreuses caractéristiques avantageuses, ce qui en fait une source à hautes performances :

- la fenêtre micro-onde d'étanchéité est située avant un coude à 90°, ce qui lui permet de ne pas être recouverte de métal ;
- la fenêtre micro-onde d'étanchéité est située dans un champ magnétique supérieur à celui de la résonance cyclotron électronique RCE : le passage de la puissance micro-onde à travers la première zone de résonance cyclotron électronique dans l'air (RCE1) n'amorce pas de plasma parasite et l'absorption se produit bien sous pression réduite dans la zone de résonance cyclotron électronique sous vide (RCE2) désirée ;
- le champ magnétique statique $\vec{B}$ et la propagation de l'onde $\vec{k}$ juste avant et dans la seconde zone RCE2 sont parallèles, ce qui permet d'éviter tout phénomène de coupure et donc éviter des limitations de densité de plasma ;

- la zone d'absorption RCE2 est située à quelques centimètres à l'intérieur du coude à 90°, ce qui permet d'obtenir une forte densité de puissance micro-onde (en effet, quand on absorbe dans un plus petit volume on obtient une plus forte densité) et donc de fortes densités de plasma ; on peut éviter ainsi que la zone RCE2 soit située en dehors du coude dans la chambre de dépôt (grand volume et faible densité de puissance) ;
- la cible et le substrat peuvent être disposés parallèlement, ce qui permet d'obtenir un dépôt homogène d'une couche sur le substrat. De plus, étant donné que la zone de résonance cyclotronique électronique (autrement dit la chambre à plasma) est située dans le coude, le plasma tourne et arrive sur le substrat parallèlement à celui-ci ;
- dans la zone de résonance cyclotron électronique, du fait de sa faible section, pour une puissance donnée, la densité de puissance est très grande. Cette configuration permet de travailler à une puissance micro-onde faible (de l'ordre de quelques dizaines de Watts) et à une très faible pression (de l'ordre de quelques $10^{-5}$ mbars) ;
- la hauteur du plasma peut être augmentée pour permettre un dépôt sur de grandes surfaces, ce qui présente un réel avantage par rapport aux sources utilisant des bobines ;
- contrairement aux magnétrons, l'usure de la cible est homogène sur toute sa surface.

Les applications de la source de l'invention concernent le dépôt de couches minces par pulvérisation (métaux magnétiques ou non, oxydes, nitrures, carbures, ...) de $10^{-5}$ à $10^{-2}$ mbar, le dépôt de carbone graphite ou diamant avec des hydrocarbures ou le traitement de surfaces en géométrie linéaire extrapolable.

Brève description des dessins

- La figure 1 illustre une vue de dessus d'un premier mode de réalisation de la source à plasma de l'invention ;
- la, figure 2 illustre une vue de dessus d'un second mode de réalisation de la source à plasma de l'invention ;
- les figures 3 et 4 illustrent un détail de la courbure des lignes de champ respectivement dans le premier et le second mode de réalisation de la source à plasma de l'invention ;
- les figures SA et 5B illustrent respectivement une vue de face et une vue de côté d'une variante de réalisation du guide d'injection micro-onde connecté à la source à plasma de l'invention.

Exposé détaillé de modes de réalisation

La source à plasma de l'invention est constituée d'une enceinte à vide 10, d'un ensemble d'aimants permanents 16, 17 et 20 créant une configuration magnétique donnée et générant une nappe de plasma dans l'enceinte, et d'un coupleur 11 répartissant dans l'enceinte la puissance générée par un ou plusieurs émetteurs micro-ondes. Cette injection de puissance dans l'enceinte 10 produit l'ionisation d'un gaz sous faible pression. Une canalisation 26 permet l'injection de ce gaz 27.

Le coupleur 11 comprend un guide d'injection micro-onde 12 se terminant par un coude 13 à 90° qui est connecté à l'enceinte 10 perpendiculairement à celle-ci. Une fenêtre micro-onde d'étanchéité 15, par exemple en quartz, est disposée entre le guide d'onde d'admission 12 et le coude 13.

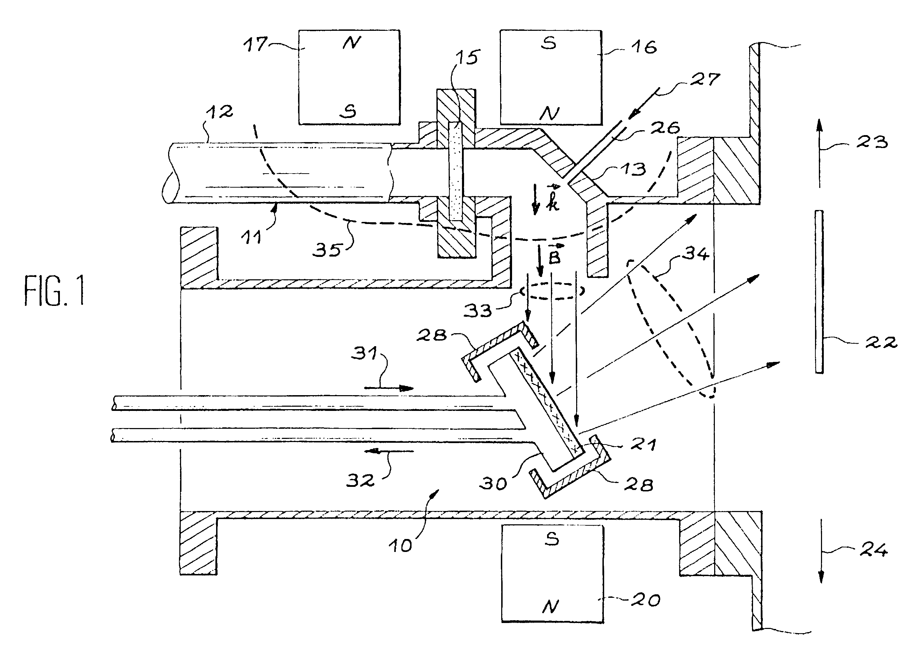

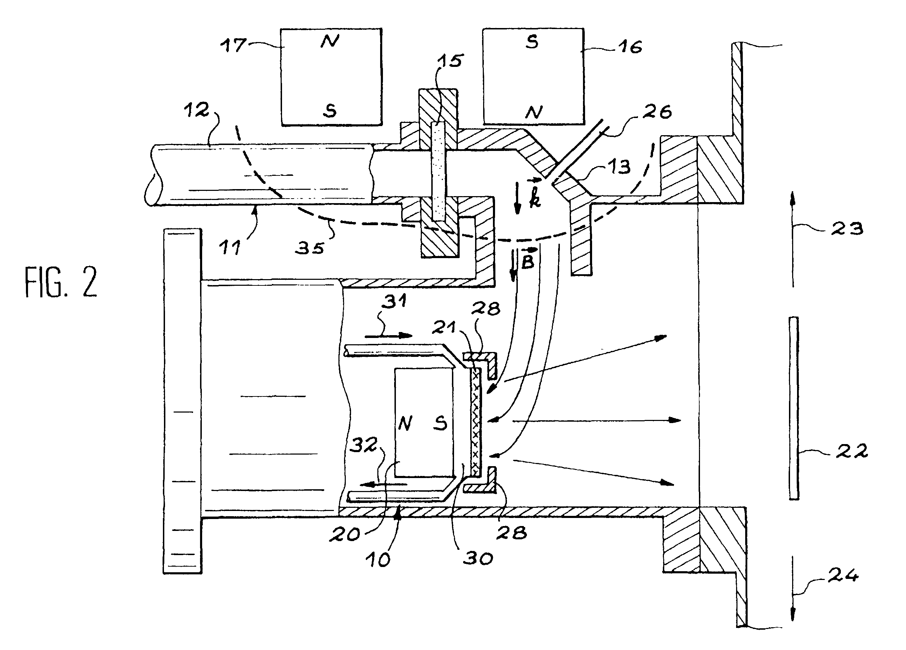

La zone de résonance cyclotron électronique est représentée par une ligne en tiretés 35 sur les figures 1 et 2, la valeur de cette résonance étant égale à RCE1 dans le guide d'injection micro-onde 12, qui est un guide à l'air, et RCE2 dans le coude 13, qui est sous vide, la flèche 24 illustrant le pompage dans l'enceinte 10.

Une cible 21 à pulvériser polarisée négativement par rapport au cache externe à la masse 28, est située dans le plasma de diffusion. Cette cible est refroidie grâce à un circuit de refroidissement 30 comportant une canalisation 31 d'amenée d'un liquide de refroidissement, par exemple de l'eau, et une canalisation 32 de retour de ce liquide.

Cette cible 21 à pulvériser peut pivoter pour obtenir une configuration cible-substrat parallèle si nécessaire.

En extrémité de l'enceinte 10 se trouve le substrat 22 à recouvrir ou traiter, mû par exemple d'un déplacement rectiligne 23, comme illustré sur les figures 1 et 2.

Un premier et un second aimants permanents 16 et 17 sont disposés de part et d'autre de la fenêtre 15. Ces aimants 16 et 17 sont installés, comme représenté sur les figures 1 et 2, avec une alternance de pôle N-S (Nord-Sud) ou S-N (Sud-Nord).

Le premier aimant 16 crée un champ magnétique $\vec{B}$ parallèle à la propagation micro-onde $\vec{k}$. Il crée un champ de module RCE2 dans le coude 13 situé en aval jusqu'au lieu désiré. Combiné au second aimant 17, il crée un fort champ au niveau de la fenêtre 15. Du fait du coude micro-onde 13, cette fenêtre 15 est située à 90° de l'axe du plasma.

Comme illustré sur la figure 1, dans un premier mode de réalisation un troisième aimant 20 est disposé de l'autre côté de la cavité 10, au même niveau que le premier aimant 16, le premier et le troisième aimants 16 et 20 étant disposés en série de pôles (N-S ou S-N).

Ce troisième aimant 20 est utilisé pour ramener les lignes de champ sur la cible 21 et augmenter ainsi la densité ionique de pulvérisation. Ainsi les lignes de champ magnétique convergent vers la cible 21 pour obtenir la densité d'ions la plus élevée possible sur celle-ci : la diffusion du plasma 33 suit les lignes de champ magnétique et la densité de courant est approximativement proportionnelle au champ magnétique (le flux magnétique et le courant total se conservent le long de la diffusion). S'il n'y avait pas de reprise de flux grâce à ce troisième aimant 20, les lignes de champ divergeraient et ainsi la densité de plasma diminuerait.

L'injection d'une puissance micro-onde dans le guide d'onde 12 à travers la fenêtre d'étanchéité 15 produit l'ionisation du gaz dans la zone 35 de résonance cyclotron électronique (résonance cyclotron électronique, par exemple à 0,0875 Tesla (875 Gauss)) situé à quelques centimètres à l'intérieur du coude 13 sous vide. Ce coude à 90° permet de protéger la fenêtre 15 contre tout recouvrement métallique qui provoquerait une réflexion de la puissance micro-onde incidente. Le plasma ainsi créé diffuse le long des lignes de champ magnétique jusqu'à la cible 15 polarisée négativement (-100 à -1 000 Volts typiquement). Les ions accélérés vers la cible 21 permettent l'éjection d'atomes pulvérisés vers le substrat 22 en un flux 34.

Dans un second mode de réalisation, illustré sur la figure 2, le troisième aimant 20 est disposé derrière la cible 21. Le premier et le troisième aimant 16 et 20 sont alors disposés en série de pôles (N-S ou S-N).

Ainsi, dans un premier mode de réalisation illustré sur la figure 1, la cible 21 peut être inclinée, les lignes de champ étant parallèles au guide d'onde en sortie, le premier et le troisième aimants étant en série Nord-Sud ou Sud-Nord et, dans un second mode de réalisation illustré sur la figure 2, la cible 21 peut être parallèle au substrat, les lignes de champ étant courbées par le troisième aimant situé derrière la cible.

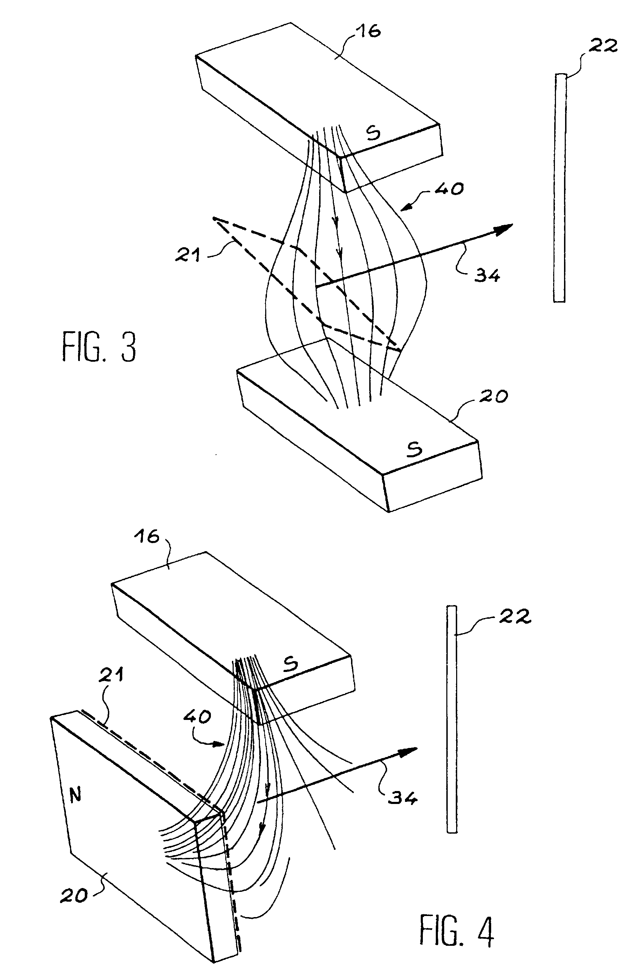

Un détail de courbure des lignes de champ 40 est donné sur les figures 3 et 4 respectivement pour le premier et le second mode de réalisation.

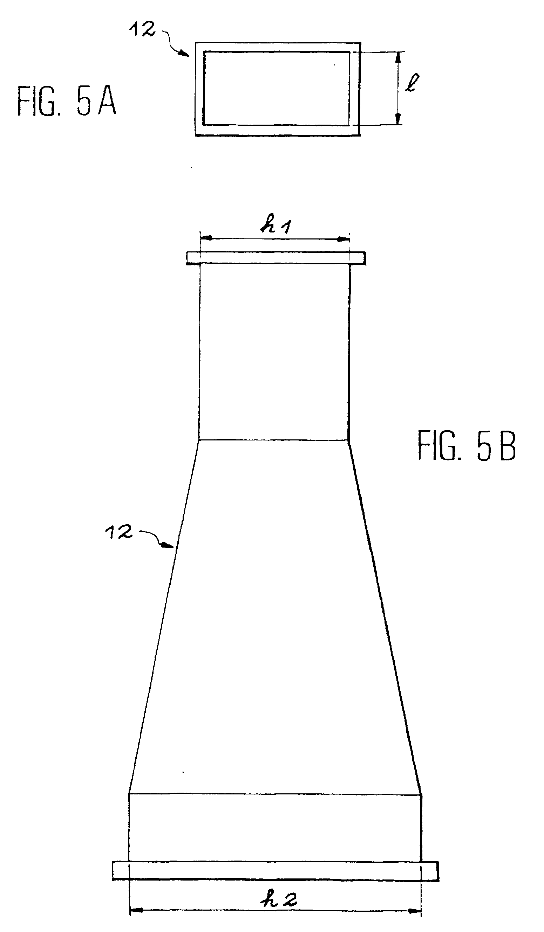

La hauteur du plasma peut être augmentée par l'augmentation de la hauteur d'injection micro-onde 12 du guide par une extension de celui-ci, comme illustré sur la figure 5. Dans cette variante de réalisation, le guide d'injection micro-onde 12 a une hauteur h2 du côté de la fenêtre micro-onde 15, représentée aux figures 1 et 2, et une hauteur h1 du côté d'une bride d'injection micro-onde (émetteur). Ce guide peut être un guide de type WR 340 pour une onde de fréquence f=2,45 Ghz, avec les dimensions suivantes : h1 = 86 mm, h2 = 172 mm, l = 43 mm.

REFERENCES

[1] « Electron Cyclotron Resonance Microwave Plasma-Based Technique For Sputter-Deposition Of Chromium Films » de E. Touchais, M. Delaunay et Y. Pauleau (Proceedings Of The 5th Internatinal Symposium On Trends And New Applications In Thin Films, Colmar, France, 1-3 avril, 1996 et thèse de E. Touchais, Institut National Polytechnique de Grenoble, France, 23 Juillet 1996)

[2] « Electron Cyclotron Resonance Plasma Deposition Technique Using Raw Material Supply By Sputtering » de T. Ono, C. Takahashi et S. Matsuo (Japan J. Appl. Phys. 23, L534, 1984)

[3] « Oxide Film Deposition By Radio Frequency Sputtering With Electron Cyclotron Resonance Plasma Stimulation » de M. Matsuoka et S. Tohno (J. Vac. Sc. Technol. A13, 2427, 1995)

[4] « A Few Techniques For Preparing Conductive Material Films For Sputtering-Type Electron Cyclotron Resonance Microwave Plasma » de M. Matsuoka et K. Ono (Japan J. Appl. Phys. 28, L503, 1989)

[5] « Permanent Magnet Electron Cyclotron Resonance Plasma Source With Remote Window » de L.A. Berry et S.M. Gorbatkin (J. Vac. Sci. Technol. A13, 343, 1995)

[6] « Long Electron Cyclotron Resonance Plasma Source For Reactive Sputtering » de T. Yasui, K. Nakase, H. Tahara et T. Yoshikawa (Japan J. Appl. Phys. 35, 5495, 1996)

[7] « Microwave-Enhanced Magnetron Sputtering » de Y. Yoshida (Rev. Sci. Instrum. 63, 179, 1992)

[8] « Highly Homogeneous Silica Coatings For Optical And protective Applications Deposited By PECVD At Room Temperature In A Planar Uniform Distributed Electron Cyclotron Resonance Plasma Reactor » de J.C. Rostaing, F. Coeuret, J. Pelletier, T. Lagarde et R. Etemadi (Thin Solid Films 270, 1995, pages 49-54)

[9] Brevet français FR-2 701 797 (demande n° 93 01847 du 18 février 1993) de G. Briffod et T.K. Nguyen, « Coupleur de transfert d'une puissance micro-onde vers une nappe de plasma et source micro-onde linéaire pour le traitement de surfaces par plasma »

**Revendications**

1.  Source à plasma micro-onde linéaire, comprenant :

    -   une enceinte étanche (10) ;
    -   des moyens (16, 17) pour créer un champ magnétique dans l'enceinte et générer une nappe de plasma ;
    -   des moyens de couplage (11) entre des moyens d'émission micro-onde et la nappe de plasma dans l'enceinte ;
    -   une cible (21) à pulvériser, isolée électriquement de l'enceinte (10) et portée à une tension de polarisation négative, située dans la nappe de plasma ;

- des moyens de pompage (24) pour faire le vide dans l'enceinte (10) ;
- des moyens d'injection de gaz (27) pour le contrôle des espèces ioniques de la nappe de plasma ;

de manière à ce que les ions accélérés vers la cible permettent l'éjection d'atomes pulvérisés vers un substrat (22) à traiter ;

**caractérisé en ce que** les moyens de couplage comprennent un guide d'injection micro-onde (12) suivi d'un coude à 90° (13) débouchant dans l'enceinte, perpendiculairement à celle-ci, une fenêtre micro-onde d'étanchéité (15) étant située entre le guide d'injection micro-onde (12) et le coude à 90° (13), de manière à produire l'ionisation du gaz en une zone de résonance cyclotron électronique (35) située à quelques centimètres à l'intérieur du coude (13), qui est sous vide, et **en ce que** les moyens pour créer un champ magnétique comprennent un premier et un second aimants permanents (16, 17) disposés de part et d'autre de cette fenêtre (15), ces aimants (16, 17) étant installés avec une alternance de pôles.

2. Source selon la revendication 1, dans laquelle la cible est refroidie grâce à un circuit de refroidissement (30) comportant une canalisation (31) d'amenée d'un liquide de refroidissement et une canalisation (32) de retour de ce liquide.

3. Source selon la revendication 1, dans laquelle un troisième aimant (20) est disposé de l'autre côté de l'enceinte (10) par rapport au premier aimant (16) et au même niveau que celui-ci, le premier et le troisième aimant (16, 20) étant disposés en série pôles.

4. Source selon la revendication 1, dans laquelle un troisième aimant (20) est disposé derrière la cible (21), le premier et le troisième aimant (16, 20) étant alors disposés en série de pôles.

5. Source selon la revendication 1, dans laquelle la cible (21) est parallèle au substrat (22).

6. Source selon la revendication 1, dans laquelle le guide d'injection micro-onde (12) a une hauteur qui augmente de son entrée vers sa sortie, connectée à la fenêtre micro-onde.

**Patentansprüche**

1. Lineare Mikrowellen-Plasmaquelle, umfassend:

- einen dichten Behälter (10);
- Einrichtungen (16, 17) zum Erzeugen eines Magnetfeldes in dem Behälter und zum Erzeugen einer Plasmaschicht;
- Kopplungseinrichtungen (11) zwischen Mikrowellen-Emissionseinrichtungen und der Plasmaschicht in dem Behälter;
- ein in der Plasmaschicht befindliches, zu zerstäubendes Target (21), von dem Behälter (10) elektrisch isoliert und auf eine negative Polarisierungsspannung gebracht;
- Pumpeinrichtungen (24), um in dem Behälter (10) ein Vakuum zu erzeugen;
- Einrichtungen zum Einspeisen von Gas (27) zur Kontrolle der Ionenarten der Plasmaschicht; so dass die in Richtung Target beschleunigten Ionen das Ausschleudern zerstäubter bzw. abgedampfter Atome in Richtung eines zu behandelnden Substrats (22) ermöglichen;

**dadurch gekennzeichnet,**
**dass** die Kopplungseinrichtungen einen Mikrowelleninjektionsleiter (12) umfassen, auf den eine 90°-Biegung (13) folgt, die in dem Behälter mündet, senkrecht zu diesem, wobei ein Abdichtungs-Mikrowellenfenster (15) sich zwischen dem Mikrowellen-Injektionsleiter (12) und der 90°-Biegung (13) befindet, so dass die Ionisierung des Gases in einer Elektronenzyklotronresonanzzone (35) stattfindet, die sich einige Zentimeter im Innern der Biegung (13) befindet, in der Vakuum herrscht, und dadurch, dass die Magnetfelderzeugungseinrichtungen einen ersten und einen zweiten Permanentmagneten (16, 17) umfassen, angeordnet beiderseits dieses Fensters (15), und diese Magneten (16, 17) mit einer Polwechseleinrichtung installiert sind.

2. Quelle nach Anspruch 1, bei der das Target mit Hilfe eines Kühlkreises (30) gekühlt wird, der eine Zuführungsleitung (31) einer Kühlflüssigkeit sowie eine Rückführungsleitung (32) dieser Flüssigkeit umfasst.

3. Quelle nach Anspruch 1, bei der ein dritter Magnet (20) auf der anderen Seite des Behälters (10) angeordnet ist, bezogen auf den ersten Magneten (16) und in gleicher Höhe mit diesem, wobei der erste und der dritte Magnet (16, 20) in Pol-Serie bzw. - Reihenfolge angeordnet sind.

4. Quelle nach Anspruch 1, bei der ein dritter Magnet (20) hinter dem Target (21) angeordnet ist, wobei der erste und der dritte Magnet (16, 20) dann in Pol-Serie bzw. - Reihenfolge angeordnet sind.

5. Quelle nach Anspruch 1, bei der das Target (21) zum Substrat (22) parallel ist.

6. Quelle nach Anspruch 1, bei der der Mikrowellen-Injektionsleiter (12) eine Höhe hat, die von seinem Eingang in Richtung seines mit dem Mikrowellenfenster verbundenen Ausgangs, zunimmt.

**Claims**

1. Linear microwave plasma source comprising:

   - a leaktight chamber (10);
   - means (16, 17) for creating a magnetic field in the chamber and for generating a plasma stream;
   - means (11) for coupling the microwave source to the plasma stream inside the chamber;
   - a sputtering target (21) that is located inside the plasma stream and electrically insulated from the chamber (10) and charged with negative polarity;
   - pump means (24) for creating negative pressure inside the chamber (10);
   - means (27) for injecting gas for controlling the ionic species of the plasma stream;

   such that the ions accelerated onto a target cause ejection of sputtered atoms onto a substrate (22) to be treated;
      **characterized by** the fact that the said coupling means comprise a microwave injection guide (12) followed by a 90° elbow (13) opening perpendicularly into the chamber, a leaktight microwave window (15) being located between the microwave injection guide (12) and the 90° elbow (13) such that they cause ionization of the gas in a zone of electron cyclotron resonance (35) located a few centimeters inside the elbow (13) and under negative pressure, and by the fact that the means for creating a magnetic field comprise first and second permanent magnets (16, 17) disposed either side of said window (15), said magnets (16, 17) being installed with alternating polarity.

2. Source of claim 1 wherein the target is cooled by means of a cooling circuit (30) comprising pipes that supply (31) and drain (32) liquid coolant.

3. Source of claim 1 wherein a third magnet (20) is disposed on the opposite side of the chamber (10) from the first magnet (16) and at the same height as the said first magnet, the poles of the first and third magnets (16, 20) being disposed in series.

4. Source of claim 1 wherein a third magnet (20) is disposed behind the target (21), the poles of the first and third magnets (16, 20) being disposed in series.

5. Source of claim 1 wherein the target (21) is disposed parallel to the substrate (22).

6. Source of claim 1 wherein microwave admission guide (12) is disposed so that its height increases from its inlet to its outlet that is connected to the microwave window.

FIG. 1

EP 0 932 183 B1

FIG. 2

FIG. 3

FIG. 4

12

FIG. 5 A

$\ell$

$h_1$

FIG. 5 B

12

$h_2$